# EUROPEAN PATENT APPLICATION

(11) **EP 4 443 723 A1**
(43) Date of publication of application: **09.10.2024**
(21) Application number: 23166657.9
(22) Date of filing: 05.04.2023
(51) Int. Cl.: H02M 1/00, G01R 19/00, G01R 19/10, G01R 19/175, H02M 3/335, H05B 45/00, H05B 45/382, H05B 45/385, H05B 45/392

(54) **PRIMARY-SIDE SWITCHED ISOLATED CONVERTER, METHOD OF OPERATING THE SAME, AND LUMINAIRE COMPRISING SAID CONVERTER**

(71) Applicant: Tridonic GmbH & Co. KG, 6851 Dornbirn (AT)
(72) Inventor: Auer, Hans, 6850 Dornbirn (AT); Saccavini, Lukas, 6850 Dornbirn (AT); Stark, Stefan, 6850 Dornbirn (AT); Romano, Fabio, 6850 Dornbirn (AT); Kucera, Clemens, 6850 Dornbirn (AT); Schneider, Miguel Philipp, 6850 Dornbirn (AT); Lochmann, Frank, 6850 Dornbirn (AT)
(74) Representative: Rupp, Christian

(57) **Abstract**

A primary-side switched isolated converter (1) comprises a sensing element, e.g. shunt resistor (122), being configured to measure a secondary-side signal (123, U_{fb}) of a secondary-side circuit (12x) of the converter (1). The converter (1) further comprises a pair of isolation resistors (133, R₂; 134, R₄), being configured to transmit first and second differential signals (11502, Ui, 11504, U₂) being indicative of the measured secondary-side signal (123, U_{fb}) across an isolation barrier (131) of the converter (1) to an evaluation circuit (115) of a primary-side circuit (11x) of the converter (1), the evaluation circuit (115) being configured to acquire the measured secondary-side signal (123, U_{fb}) from a difference (11511, Uₒ) of the first and second differential signals (11502, Ui, 11504, U₂) at periodic time instants in dependence of a primary-side signal of the primary-side circuit (11x) of the converter (1). This avoids the impact of common-mode voltage and yields a more cost-efficient secondary-side sensing.

## Description

### Technical Field

The present disclosure relates to lighting technology, and in particular to a primary-side switched isolated converter.

### Background Art

SELV-rated LED converters with primary-side control may sense an LED current in a secondary-side circuit of the converter and transfer the information across the SELV barrier to the primary-side control unit, for example using opto-couplers or a current transformer. Both are relatively costly. A more cost-efficient approach may be based on direct sensing of the LED current using SELV-rated resistors. The main issue of this approach is the impact of common-mode voltage (i.e. the potential difference between earth and ground of the device). High voltage differential probes avoid this problem by using perfectly matched attenuator inputs and a precision instrumentation output amplifier, which is expensive, too.

### Summary

It is an objective to overcome the above-mentioned and other drawbacks. The foregoing and other objectives are achieved by the embodiments as defined in the appended independent claims. Preferred embodiments are set forth in the dependent claims and in the following description and drawings.

A first aspect of the present disclosure relates to a primary-side switched isolated converter. The converter comprises a sensing element, being configured to measure a secondary-side signal of a secondary-side circuit of the converter. The converter further comprises a pair of isolation resistors, being configured to transmit first and second differential signals being indicative of the measured secondary-side signal across an isolation barrier of the converter to an evaluation circuit of a primary-side circuit of the converter, the evaluation circuit being configured to acquire the measured secondary-side signal from a difference of the first and second differential signals at periodic time instants in dependence of a primary-side signal of the primary-side circuit of the converter.

The evaluation circuit may comprise a first pull-down resistor, being configured to provide the transmitted first differential signal at the primary-side circuit of the converter; and a second pull-down resistor, being configured to provide the transmitted second differential signal at the primary-side circuit of the converter.

The evaluation circuit may further comprise a termination resistor, being interposed between the transmitted first and second differential signals.

The evaluation circuit may further comprise a differential amplifier, being configured to provide the difference of the first and second differential signals in accordance with a predefined gain factor.

The primary-side signal may comprise a partial voltage of an alternating current, AC, supply voltage of the converter.

The evaluation circuit may further comprise a comparator circuit, being configured to indicate zero crossings of the primary-side signal as falling or rising edges of an output signal of the comparator circuit. The periodic time instants may comprise time instants of the falling or rising edges of the output signal.

A frequency of the periodic time instants may comprise twice a frequency of the primary-side signal.

The primary-side signal may comprise one of: the transmitted first differential signal, and the transmitted second differential signal.

The evaluation circuit may further comprise a comparator circuit, being configured to indicate zero crossings in falling signal portions of the primary-side signal as falling edges of an output signal of the comparator circuit. The periodic time instants may comprise time instants of the falling edges of the output signal.

A frequency of the periodic time instants may comprise less than a tenth, preferably less than a hundredth, of a switching frequency of a primary-side switch of the converter.

The evaluation circuit may further comprise a sample-and-hold, S&H, circuit, being configured to sample and hold the difference of the first and second differential signals in accordance with the output signal of the comparator circuit

The evaluation circuit may further comprise an application-specific integrated circuit, ASIC.

A second aspect of the present disclosure relates to a luminaire, comprising a light-emitting device, LED, light source; and a converter of the first aspect.

A third aspect of the present disclosure relates to a method of operating a primary-side switched isolated converter. The method comprises measuring, by a sensing element, a secondary-side signal of a secondary-side circuit of the converter. The method further comprises transmitting, by a pair of isolation resistors, first and second differential signals being indicative of the measured secondary-side signal across an isolation barrier of the converter to an evaluation circuit of a primary-side circuit of the converter. The method further comprises acquiring, by the evaluation circuit, the measured secondary-side signal from a difference of the first and second differential signals at periodic time instants in dependence of a primary-side signal of the primary-side circuit of the converter.

### Advantageous Effects

The present disclosure avoids the impact of common-mode voltage (i.e. the potential difference between earth and ground of the device) by passive differential sensing across an SELV isolation barrier of the LED converter and sampling the differential sensing signal of the LED current at zero-crossings of said common-mode voltage, since at said zero-crossings a sample value of the differential sensing signal is comparable to a value of the secondary-side sensing signal.

This yields a more cost-efficient secondary-side sensing of an LED current for a primary-side controlled LED converter.

The technical effects and advantages described above in relation with the converter equally apply to the method of operating the same having corresponding features.

### Brief Description of Drawings

The above-described aspects and implementations will now be explained with reference to the accompanying drawings, in which the same or similar reference numerals designate the same or similar elements.

The features of these aspects and implementations may be combined with each other unless specifically stated otherwise.

The drawings are to be regarded as being schematic representations, and elements illustrated in the drawings are not necessarily shown to scale. Rather, the various elements are represented such that their function and general purpose become apparent to those skilled in the art.
- FIG. 1: illustrates a luminaire and a converter in accordance with the present disclosure;
- FIG. 2: illustrates an evaluation circuit of the converter in accordance with the present disclosure;
- FIG. 3: illustrates a first modification of the evaluation circuit of FIG. 2 in accordance with the present disclosure;
- FIG. 4: illustrates a second modification of the evaluation circuit of FIG. 2 in accordance with the present disclosure;
- FIG. 5: illustrates waveforms of various primary-side signals in accordance with the present disclosure; and
- FIG. 6: illustrates a method of operating a converter in accordance with the present disclosure.

### Detailed Descriptions of Drawings

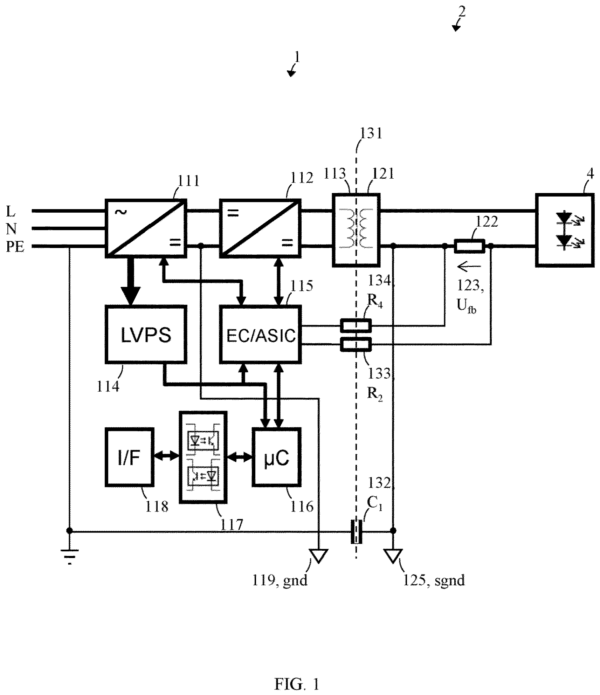

FIG. 1 illustrates a luminaire 2 and a converter 1 in accordance with the present disclosure.

The luminaire 2 comprises a light-emitting device (LED) light source 4 on the right, and the primary-side switched isolated converter 1 on the left.

In a power path, the converter 1 may comprise an AC/DC stage 111, a DC/DC stage 112, and a transformer 113, 121 being configured to form a Safety Extra Low Voltage (SELV) isolation barrier 131 between a primary-side circuit 11x and a secondary-side circuit 12x of the converter 1.

Off the power path, the converter 1 may further comprise an evaluation circuit (EC) 115 to be explained in more detail below, and a microcontroller (µC) 116, opto-couplers 117 and a control interface (I/F) 118 for lighting control in accordance with one or more of Digital Addressable Lighting Interface (DALI), Digital Serial Interface (DSI) and switchDIM (SD). The converter 1 may further comprise a low-voltage power supply (LVPS) circuit 114 being configured to supply the evaluation circuit 115 and the µC 116 off the AC/DC stage 111.

The primary-side circuit 11x may be referenced to a protective earth (PE) potential of an alternating current (AC) supply of the converter 1, such as a mains supply, and/or to a primary-side ground 119, *gnd* potential forming between the AC/DC stage 111 and the DC/DC stage 112.

The secondary-side circuit 12x may be referenced to a secondary-side ground 125, *sgnd* potential.

The converter 1 may comprise a safety class Y-capacitor 132, Ci being interposed between the primary-side PE potential and the secondary-side ground 125, *sgnd* potential for suppression of electro-magnetic interference (EMI). For example, the Y- capacitor 132, Ci may comprise a value of 3,3nF.

The converter 1 further comprises a sensing element 122, such as a shunt resistor as shown in FIG. 1, being configured to measure a secondary-side signal 123, U_{fb} of a secondary-side circuit 12x of the converter 1, such as a voltage being indicative of an LED current of the LED light source 4. The sensing element 122 may be also be formed by a current sense transformer or a resistive voltage divider used to measure a voltage of the LED light source 4 which is in correlation with the LED current and thus can be indicative for the LED current.

As used herein, a shunt may refer to an electronic device that provides a low-resistance path for electric current.

The converter 1 further comprises a pair of isolation resistors 133, R₂; 134, R₄ to be explained in more detail below. For example, the isolation resistors 133, R₂; 134, R₄ may be SELV-rated and may respectively comprise values of 10MΩ.

In particular, the evaluation circuit 115 may comprise an application-specific integrated circuit, ASIC, for signal evaluation.

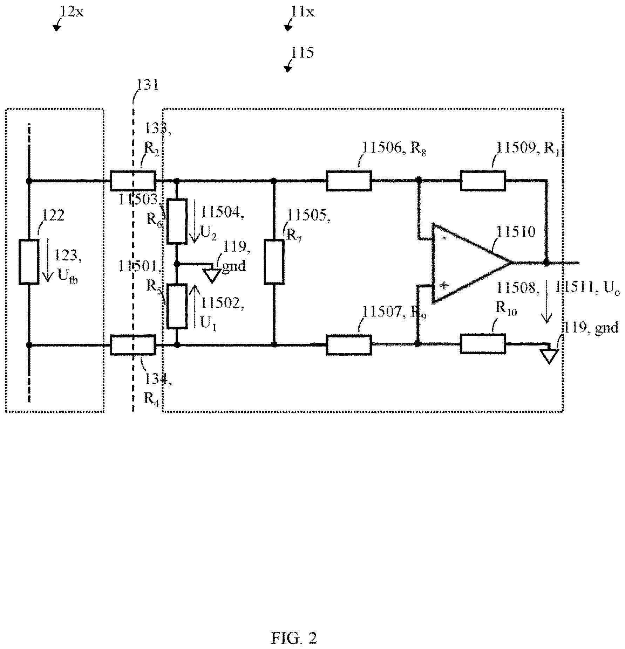

FIG. 2 illustrates an evaluation circuit 115 of the converter 1 in accordance with the present disclosure.

In accordance with the depicted portion of the converter 1, the isolation barrier 131 of the converter 1 separates the secondary-side circuit 12x on the left and the primary-side circuit 11x on the right.

The sensing element 122 of FIG. 1 for measuring the secondary-side signal 123, U_{fb} forms part of the secondary-side circuit 12x.

The pair of isolation resistors 133, R₂; 134, R₄ of FIG. 1 is interposed in parallel between the secondary-side circuit 12x and the primary-side circuit 11x and is configured to transmit first and second differential signals 11502, U₁, 11504, U₂ being indicative of the measured secondary-side signal 123, U_{fb} across the isolation barrier 131 of the converter 1 to the evaluation circuit 115 of the primary-side circuit 11x of the converter 1.

As used herein, differential signaling may refer to a method of electric information transmission using two voltage signals which are equal in magnitude but of opposite polarity, each in its own transmission line (i.e., conductor).

The evaluation circuit 115 may comprise a first pull-down resistor 11501, R₅, being configured to provide the transmitted first differential signal 11502, U₁ at the primary-side circuit 11x of the converter 1; and a second pull-down resistor 11503, R₆, being configured to provide the transmitted second differential signal 11504, U₂ at the primary-side circuit 11x of the converter 1 (providing the signals at the primary-side circuit 11x may mean providing the signals with reference to the local primary-side ground 119, *gnd* potential). For example, the first pull-down resistor 11501, R₅ and the second pull-down resistor 11503, R₆ may respectively comprise values of 100kΩ.

In reality, resistor values may differ. As a typical example, the first pull-down resistor 11501, R₅ may comprise a value of 100kΩ and the second pull-down resistor 11503, R₆ may comprise a value of 101kΩ. A better match may entail an additional manufacturing step, such as laser trimming, which is an expensive process step. In order to avoid the additional effort and expense of trimming, the present disclosure proposes a different approach wherein the measured secondary-side signal 123, U_{fb} may be acquired from a difference 11511, Uₒ of the first and second differential signals 11502, U₁, 11504, U₂ only at periodic time instants (see below).

The evaluation circuit 115 may further comprise a termination resistor 11505, R₇, being interposed between (the differential transmission lines of) the transmitted first and second differential signals 11502, U₁, 11504, U₂. For example, the termination resistor 11505, R₇ may comprise a value of 4MΩ.

The evaluation circuit 115 may further comprise a differential amplifier 11506-11510, R₈-R₁₁, being configured to provide the difference 11511, Uₒ of the first and second differential signals 11502, U₁, 11504, U₂ in accordance with a predefined gain factor. For instance, the predefined gain factor may correspond to R₁₁/R₈ (or R₁₀/R₉) if R₈ = R₉ and R₁₀ = R₁₁. For example, the resistors 11506, R₈ and 11507, R₉ may respectively comprise values of 100Ω, and the resistors 11508, R₁₀ and 11509, R₁₁ may respectively comprise values of 10kΩ, resulting in a predefined gain factor of 100. Alternatively, the predefined gain factor may correspond to 1 (unity gain) if R₈ = R₉ = R₁₀ = R₁₁.

The evaluation circuit 115 is thus configured to acquire, from the above-identified difference 11511, Uₒ of the first and second differential signals 11502, U₁, 11504, U₂, the measured secondary-side signal 123, U_{fb} at periodic time instants in dependence of a primary-side signal of the primary-side circuit 1 1x of the converter 1.

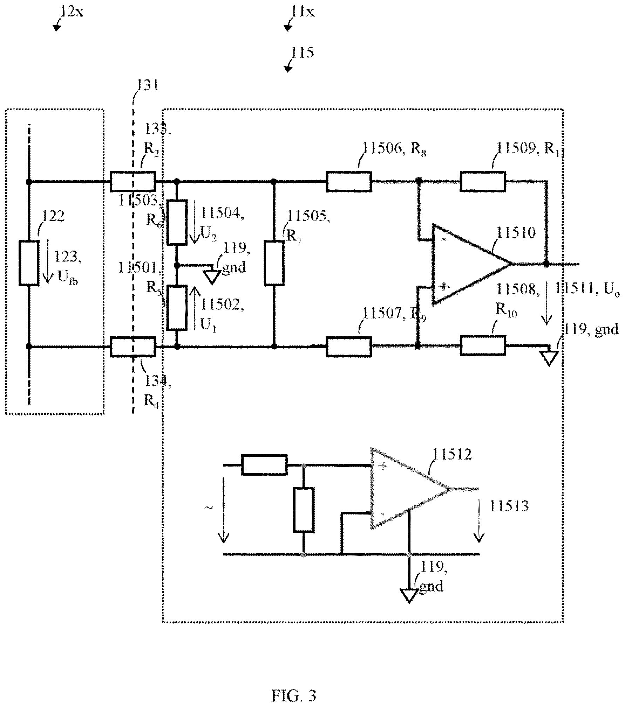

Different implementations of said dependency will be explained in connection with FIGs. 3 to 5 below.

FIG. 3 illustrates a first modification of the evaluation circuit of FIG. 2 in accordance with the present disclosure.

In accordance with FIG. 3, the primary-side signal may comprise a partial voltage of an alternating current (AC) supply voltage of the converter 1.

The evaluation circuit 115 may further comprise a comparator circuit 11512.

At its positive (+) input terminal, the comparator circuit 11512 may receive said partial voltage being provided by a resistive voltage divider.

At its negative (-) input terminal, the comparator circuit 11512 may receive a reference voltage such that it is configured to indicate zero crossings of the primary-side signal as falling or rising edges of an output signal 11513, U_{cmp} of the comparator circuit 11512. For example, the reference voltage may comprise the primary-side ground 119, *gnd* potential.

In other words, the periodic time instants at which the measured secondary-side signal 123, U_{fb} may be acquired may comprise time instants of the falling or rising edges of the output signal 11513, U_{cmp} of the comparator circuit 11512.

It follows that a frequency of the periodic time instants may comprise twice a frequency of the primary-side signal.

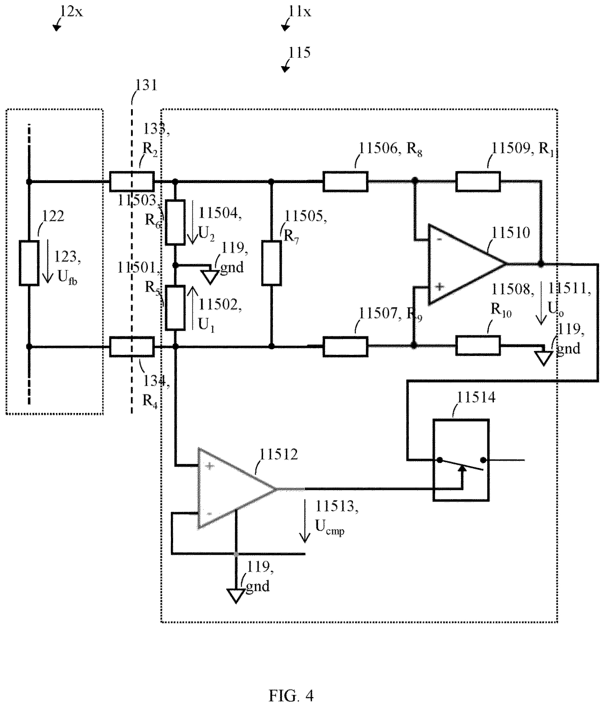

FIG. 4 illustrates a second modification of the evaluation circuit of FIG. 2 in accordance with the present disclosure.

In accordance with FIG. 4, the primary-side signal may comprise one of the transmitted first differential signal 11502, U₁ (as shown) and the transmitted second differential signal 11504, U₂ (not shown).

The evaluation circuit 115 may further comprise a comparator circuit 11512.

At its positive (+) input terminal, the comparator circuit 11512 may receive said primary-side signal.

At its negative (-) input terminal, the comparator circuit 11512 may receive a reference voltage such that it is configured to indicate zero crossings in falling signal portions of the primary-side signal as falling edges of an output signal 11513, U_{cmp} of the comparator circuit 11512. For example, the reference voltage may comprise the primary-side ground 119, *gnd* potential.

That is to say, the periodic time instants at which the measured secondary-side signal 123, U_{fb} may be acquired may comprise time instants of the falling edges of the output signal 11513, U_{cmp} of the comparator circuit 11512.

Accordingly, a frequency of the periodic time instants may comprise less than a tenth, preferably less than a hundredth, of a switching frequency of a primary-side switch (not shown) of the converter 1.

The evaluation circuit 115 may further comprise a sample-and-hold (S&H) circuit 11514, being configured to sample and hold the difference 11511, Uₒ of the first and second differential signals 11502, U₁, 11504, U₂ in accordance with the output signal 11513, U_{cmp} of the comparator circuit 11512.

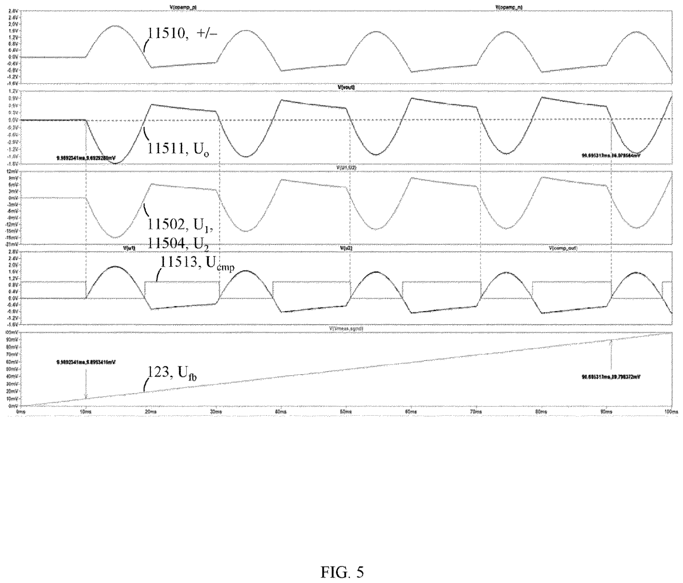

FIG. 5 illustrates waveforms of various primary-side signals in accordance with the present disclosure.

A first/top row of FIG. 5 shows waveforms applied at a positive (+) input terminal and at a negative (-) input terminal of the operational amplifier 11510 of the differential amplifier 11506-11510, Rs-R₁₁. Due to their similarity, they look like a single waveform.

A second row of FIG. 5 shows a waveform of an output signal 11511, Uₒ of the operational amplifier 11510, i.e., the - potentially amplified - difference 11511, Uₒ of the first and second differential signals 11502, U₁, 11504, U₂. The skewed waveform is due to a mismatch of the first pull-down resistor 11501, R₅ and the second pull-down resistor 11503, R₆ as mentioned above, and indicates why trimming would be desirable in an conventional approach.

A third row of FIG. 5 shows a waveform of the underlying first and second differential signals 11502, U₁, 11504, U₂.

A fourth row of FIG. 5 shows a waveform of the output signal 11513, U_{cmp} of the comparator circuit 11512 of FIG. 4.

A fifth/bottom row of FIG. 5 shows a waveform of the secondary-side signal 123, U_{fb} of the secondary-side circuit 12x of the converter 1.

Note that the values of the measured secondary-side signal 123, U_{fb} (fifth row) and of the output signal 11511, Uₒ of the operational amplifier 11510 (second row) sufficiently correspond to one another at periodic time instants coinciding with the time instants of the falling edges of the output signal 11513, U_{cmp} of the comparator circuit 11512 (or of the output signal 11516 of the digital comparator circuit 11515).

When sampling the output signal 11511, Uₒ of the operational amplifier 11510 the falling edges of the output signal 11513, U_{cmp} of the comparator circuit 11512, the sampled values are comparable to those of the measured secondary-side signal 123, U_{fb}.

Accordingly, the evaluation circuit 115 is configured to acquire the measured secondary-side signal 123, U_{fb} (fifth row) from the output signal 11511, Uₒ of the operational amplifier 11510 (second row) at said periodic time instants.

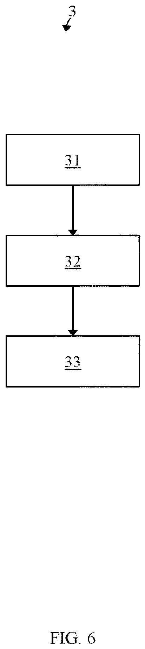

FIG. 6 illustrates a method 3 of operating a converter 1 in accordance with the present disclosure.

The method 3 is for operating a primary-side switched isolated converter 1 of the first aspect.

The method 3 comprises a step of measuring 31, by a sensing element 122, a secondary-side signal 123, U_{fb} of a secondary-side circuit 12x of the converter 1.

The method 3 further comprises a step of transmitting 32, by a pair of isolation resistors 133, R₂; 134, R₄, first and second differential signals 11502, U₁, 11504, U₂ being indicative of the measured secondary-side signal 123, U_{fb} across an isolation barrier 131 of the converter 1 to an evaluation circuit 115 of a primary-side circuit 11x of the converter 1.

The method 3 further comprises a step of acquiring 33, by the evaluation circuit 115, the measured secondary-side signal 123, U_{fb} from a difference 11511, Uo of the first and second differential signals 11502, U₁, 11504, U₂ at periodic time instants in dependence of a primary-side signal of the primary-side circuit 11x of the converter 1.

## Claims

1. A primary-side switched isolated converter (1), comprising
a sensing element (122), being configured to measure a secondary-side signal (123, U_{fb}) of a secondary-side circuit (12x) of the converter (1); and
a pair of isolation resistors (133, R₂; 134, R₄), being configured to transmit first and second differential signals (11502, U₁, 11504, U₂) being indicative of the measured secondary-side signal (123, U_{fb}) across an isolation barrier (131) of the converter (1) to an evaluation circuit (115) of a primary-side circuit (11x) of the converter (1);
the evaluation circuit (115) being configured to acquire the measured secondary-side signal (123, U_{fb}) from a difference (11511, Uₒ) of the first and second differential signals (11502, U₁, 11504, U₂) at periodic time instants in dependence of a primary-side signal of the primary-side circuit (1 1x) of the converter (1).

2. The converter (1) of claim 1,
the evaluation circuit (115) comprising
a first pull-down resistor (11501, R₅), being configured to provide the transmitted first differential signal (11502, U₁) at the primary-side circuit (11x) of the converter (1); and
a second pull-down resistor (11503, R₆), being configured to provide the transmitted second differential signal (11504, U₂) at the primary-side circuit (11x) of the converter (1).

3. The converter (1) of claim 1 or claim 2,
the evaluation circuit (115) further comprising
a termination resistor (11505, R₇), being interposed between the transmitted first and second differential signals (11502, U₁, 11504, U₂).

4. The converter (1) of any one of the claims 1 to 3, the evaluation circuit (115) further comprising
a differential amplifier (11506-11510, R₈-R₁₁), being configured to provide the difference (11511, Uo) of the first and second differential signals (11502, U₁, 11504, U₂) in accordance with a predefined gain factor.

5. The converter (1) of any one of the claims 1 to 4,
the primary-side signal comprising a partial voltage of an alternating current, AC, supply voltage of the converter (1).

6. The converter (1) of claim 5,
the evaluation circuit (115) further comprising
a comparator circuit (11512), being configured to indicate zero crossings of the primary-side signal as falling or rising edges of an output signal (11513, U_{cmp}) of the comparator circuit (11512);
the periodic time instants comprising time instants of the falling or rising edges of the output signal (11513, U_{cmp}).

7. The converter (1) of claim 6,
a frequency of the periodic time instants comprising twice a frequency of the primary-side signal.

8. The converter (1) of any one of the claims 1 to 4,
the primary-side signal comprising one of:
the transmitted first differential signal (11502, Ui), and
the transmitted second differential signal (11504, U₂).

9. The converter (1) of claim 8,
the evaluation circuit (115) further comprising
a comparator circuit (11512), being configured to indicate zero crossings in falling signal portions of the primary-side signal as falling edges of an output signal (11513, U_{cmp}) of the comparator circuit (11512);
the periodic time instants comprising time instants of the falling edges of the output signal (11513, Ucmp).

10. The converter (1) of claim 9,
a frequency of the periodic time instants comprising less than a tenth, preferably less than a hundredth, of a switching frequency of a primary-side switch of the converter (1).

11. The converter (1) of any one of the claims 6, 7 9 or 10,
the evaluation circuit (115) further comprising
a sample-and-hold, S&H, circuit (11514), being configured to sample and hold the difference (11511, Uₒ) of the first and second differential signals (11502, U₁, 11504, U₂) in accordance with the output signal (11513, U_{cmp}) of the comparator circuit (11512).

12. The converter of any one of the claims 1 to 11,
the evaluation circuit (115) further comprising
an application-specific integrated circuit, ASIC.

13. A luminaire (2), comprising
a light-emitting device, LED, light source (4); and
a converter (1) of any one of the claims 1 to 9.

14. A method (3) of operating a primary-side switched isolated converter (1), the method (3) comprising
measuring (31), by a sensing element (122), a secondary-side signal (123, U_{fb}) of a secondary-side circuit (12x) of the converter (1); and
transmitting (32), by a pair of isolation resistors (133, R₂; 134, R₄), first and second differential signals (11502, U₁, 11504, U₂) being indicative of the measured secondary-side signal (123, U_{fb}) across an isolation barrier (131) of the converter (1) to an evaluation circuit (115) of a primary-side circuit (11x) of the converter (1);
acquiring (33), by the evaluation circuit (115), the measured secondary-side signal (123, U_{fb}) from a difference (11511, Uo) of the first and second differential signals (11502, U₁, 11504, U₂) at periodic time instants in dependence of a primary-side signal of the primary-side circuit (11x) of the converter (1).
